# EUROPEAN PATENT APPLICATION

(11) **EP 2 750 186 A2**
(43) Date of publication of application: **02.07.2014**
(21) Application number: 13192760.0
(22) Date of filing: 13.11.2013
(51) Int. Cl.: H01L 23/498

(54) **Package structure and package method**

(30) Priority: 17.12.2012 TW 101147927
(71) Applicant: Princo Corp., Hsinchu 300 (TW)
(72) Inventor: Shaue, Gan-how, 300 Hsinchu (TW); Yang, Chih-kuang, 300 Hsinchu (TW); Guu, Yeong-yan, 300 Hsinchu (TW)
(74) Representative: Petraz, Gilberto Luigi

(57) **Abstract**

Disclosed are a package structure and a package method. The package structure comprises an IC bare die, having bare die pads formed on a surface; a flexible packaging substrate, having first pads formed on a first surface and second pads formed on a second surface; and a plurality of bumps, previously formed on the first surface of the flexible packaging substrate. The bumps have different heights, and correspond to the first pads and contact the bare die pads respectively. Pressing or heating is implemented to package the IC bare die. The package structure further comprises a printed circuit board, having a plurality of contact pads. The second pads of the flexible packaging substrate respectively contact with the contact pads via solders. Connection is implemented by pressing or heating. Extremely low stress is generated to the packaging substrate and the printed circuit board.

## Description

### BACKGROUND OF THE INVENTION

### 1. Field of the Invention

The present invention generally relates to a package structure and a package method, and more particularly to a package structure and a package method for reducing packaging stress.

### 2. Description of Prior Art

With the development of integrated circuit technology, the density rapidly increases and the corresponding package skill also becomes unprecedented and innovative. Not only the amount of the solder balls, the bumps, the pads and the electrical contacts becomes more but also the sizes thereof also gets smaller and smaller. Accordingly, the spaces among the solder balls and the bumps are constantly demanded to be diminished (fine pitch scale) to meet the design trend of microminiaturization of the electronic devices. Consequently, the thicknesses of the package substrate and the printed circuit board are also constantly getting thinner and thinner.

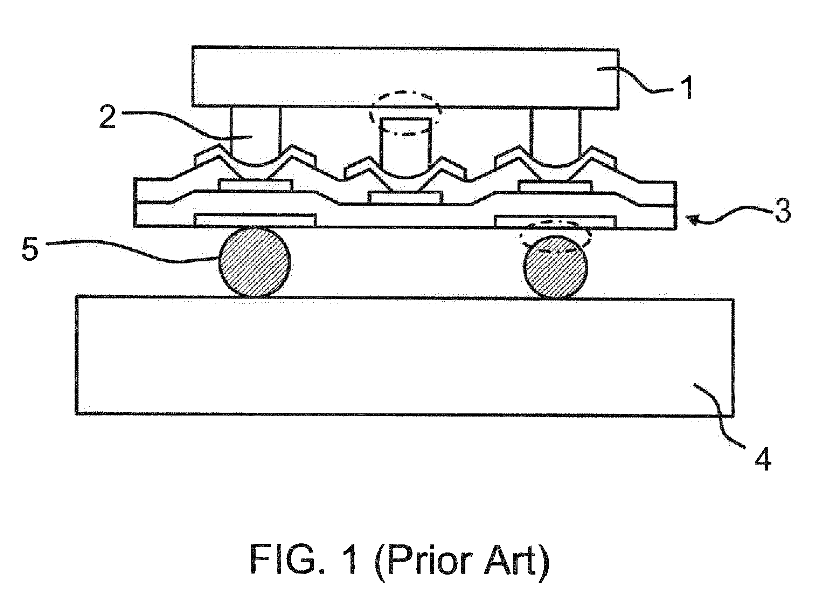

In general, for meeting the package requirements of high density integrated circuit, Flip-Chip package becomes a major technology. In early time, the diameter of the solder ball (i.e. the height, or the bump height) is about 100µm. With the density of the integrated circuit constantly raises and the package density grows as long as well. Nowadays, the stud is generally utilized instead of solder ball in the related industries. In case of spherical bump, the diameter can be about 30µm - 50µm. In case of other types of the stud, the height can be about 20µm - 30µm. As shown in FIG. 1 of the present Flip-Chip package, the IC bare die 1 comprises a plurality of pads (not shown). Several bumps (or studs) 2 which the diameters are about 30µm - 50µm or the heights are about 20µm - 30µm are previously formed on the surface of the IC bare die 1. A plurality of package pads (not shown) is formed on the upper and lower surfaces of the hard package substrate 3. The IC bare die 1 contacts with the package pads of the hard package substrate 3 via the bumps (or studs) 2 located on the upper surface of the IC bare die 1. Then, the process of pressing or heating is implemented for packaging the IC bare die 1. The pitches of the bumps (or studs) 2 are about 100µm. On demands of circuit design, the pitches of the bumps (or studs) 2 can be even smaller than 50µm.

As shown in FIG. 1, a plurality of electrical contacts (not shown) is located on the upper surface of the rigid printed circuit board (PCB) 4. Then, the hard multi-layer package substrate 3 becomes in touch with the electrical contacts on the upper surface of the rigid printed circuit board 4 via solder balls 5. After the process of pressing or heating is implemented, the IC bare die 1 is electrically connected to the rigid printed circuit board 4 through the hard package substrate 3.

As aforementioned, when the amounts of the solder balls, the studs, the pads and the electrical contacts are not so many, the hard package substrate 3 and the rigid printed circuit board 4 relatively remain to have certain thicknesses. As shown in Fig. 1, as the process of pressing or heating is implemented for packaging the IC bare die 1 with the hard multi-layer package substrate 3 or for connecting the hard multi-layer package substrate 3 and the rigid printed circuit board 4, the allowable dimensional deviations of respective components are larger. The more important thing is that as shown in figures, the phenomenon of an uneven surface of the hard multi-layer package substrate 3 does inevitably exist because of the uneven thickness, unevenness itself or impossible averaged arrangement of the metal layers and the dielectric layers because of the circuitry design. Similarly, like the hard multi-layer package substrate 3, the phenomenon of an uneven surface of the rigid printed circuit board 4 does inevitably exist because of the uneven thickness, unevenness itself or impossible averaged arrangement of the metal layers and the dielectric layers because of the circuitry design.

Generally in Flip-Chip technology, the pressure applied to the hard multi-layer package substrate 3 and the rigid printed circuit board 4 can reach up to 1-10kgf/cm² in the stud or solder ball connection process. It is obviously quite a big pressure to the studs 2, the hard multi-layer package substrate 3, the rigid printed circuit board 4 and the solder balls 5. Therefore, as executing the aforesaid package bonding and connection, the hard multi-layer package substrate 3 and the rigid printed circuit board 4 suffer a certain stress because the package bonding and the connections of many studs 2 and many solder balls 5. The pressure of such degree will not give obvious effects to the multi-layer package substrate 3 and the rigid printed circuit board 4 while the all components in package structure have certain sizes and larger thickness. In prior arts, some studs 2 are previously formed on the package substrate 3 and then the process of pressing or heating is executed for packaging the IC bare die 1. The purpose is merely to eliminate the damage to the IC bare die 1.

Furthermore, even before the aforesaid packaging bonding and connection, the IC bare die 1, the multi-layer package substrate 3 and the printed circuit board 4 are all hard and rigid components. The phenomena of the uneven surfaces of the hard multi-layer package substrate 3 and the rigid printed circuit board 4 do inevitably exist because of the uneven thickness, unevenness themselves or impossible averaged arrangement of the metal layers and the dielectric layers because of the circuitry design. Moreover, no matter how meticulously the studs 2 or the solder balls 5 are manufactured, certain differences of dimensions, sizes and appearances of many studs 2 or many solder balls 5 must exist. Therefore, missing joint or cold welding accidences may sometime happen.

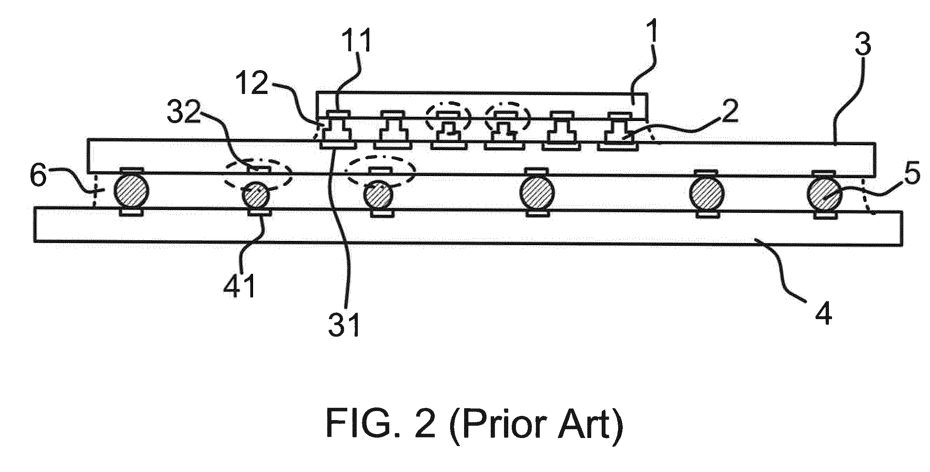

Please refer to FIG. 2, showing a status of the aforesaid components when the package bonding and connection are completed as the amounts of the solder balls, the studs, the pads and the electrical contacts increase and gets more and more, and the hard package substrate, the rigid printed circuit board are required to be thinner and thinner. As shown in FIG. 2, in the Flip-Chip process, the IC bare die 1 comprises a plurality of first pads 11. The hard package substrate 3 comprises a plurality of second pads 31 on the upper surface of the hard package substrate 3 and a plurality of third pads 32 on the lower surface of the hard package substrate 3. The rigid printed circuit board 4 comprises a plurality of electrical contacts 41 on the upper surface of the rigid printed circuit board 4.

A plurality of studs can be previously formed and located on the upper surface of the hard package substrate 3 and connected with the second pads 31 of the hard package substrate 3. After packaging the IC bare die 1 by contacting the studs and the first pads of the IC bare die 1 and implementing the process of pressing or heating and then, the third pads 32 on the lower surface of the hard package substrate 3 are contacted with the electrical contacts 41 on the upper surface of the rigid printed circuit board 4 via the solder balls 5. Then, the process of pressing or heating is implemented to finish the process of connecting the IC bare die 1 with the rigid printed circuit board 4 through the hard package substrate 3 to complete a manufacture package of an electronic device. Meanwhile, after the foregoing manufacture is done, a warpage measurement will be generally performed in a Shadow Moiré warpage measurement equipment. Most of the practical measured warpage data are from 20µm to 50µm. Obviously, the prior arts inevitably cause the warpage happening to the finished electronic device. As foresaid diameters of the studs 2 are about 30µm-50µm or the heights of the studs 2 are about 20µm-30µm. The warpage and the dimension of the studs are considerably in the same scale. Therefore, in the stud Flip-Chip package, a possible solution for the warpage of the package substrate and the printed circuit board become a significant issue.

Meanwhile, in the process of pressing or heating for packaging the IC bare die 1, non-conductive bonding material, such as epoxy 12 may be further filled between the IC bare die 1 and the hard package substrate 3 according to prior arts. The purpose is not merely to maintain the isolation status of the adjacent studs 2, first pads 11 and second pads 31. The more important is to strengthen the bonding force between the IC bare die 1 and the hard package substrate 3 against the aforesaid stress that the IC bare die 1 and the hard package substrate 3 are suffered after package bonding.

Moreover, similarly, in the process of pressing or heating for connecting the hard package substrate 3 and the rigid printed circuit board 4, non-conductive bonding material, such as epoxy 6 may be further filled between the hard package substrate 3 and the rigid printed circuit board 4 according to prior arts. The purpose is not merely to maintain the isolation status of the adjacent studs 2, first pads 11 and second pads 31. The more important is to strengthen the bonding force between the hard package substrate 3 and the rigid printed circuit board 4 against the aforesaid stress that the hard package substrate 3 and the rigid printed circuit board 4 are suffered after package bonding.

Specifically, as regarding the thickness (the distance between two metal layers or the thickness of one dielectric layer) of the present possibly manufactured package substrate can be smaller than 50µm, and even smaller than 30µm. Almost no documents show the deformation conditions of the substrates suffered from the stress. However, with the incisive observation by the inventors of the present invention, as the thickness of the substrate becomes thinner as the previously described scale, after the package bonding as shown in FIG. 2, the hard package substrate 3 and the rigid printed circuit board 4 do suffer the stress indeed because of the package bonding. Moreover, as shown in FIG. 1, the phenomena of the uneven surfaces of the hard package substrate 3 and the rigid printed circuit board 4 do inevitably exist because of the uneven thickness, unevenness themselves or impossible averaged arrangement of the metal layers and the dielectric layers because of the circuitry design. Moreover, no matter how meticulously the studs 2 or the solder balls 5 are manufactured, certain differences of dimensions, sizes and appearances of many studs 2 or many solder balls 5 must exist.

Accordingly, the package bonding fractures may result in the failure of the electronic device or increase the failure possibilities in the following manufacture procedures or during the usage lifetime of the electronic device, which utilizes such package. Therefore, the constantly existing stress between the aforesaid hard package substrate 3 and the aforesaid rigid printed circuit board 4 and package bonding fractures can be fatal to this package process. The missing joint or cold welding accidences may happen and leads to the package failure, either. The only solutions in prior arts are as previously described to fill up with the epoxy among the IC bare die 1, the hard package substrate 3 and the rigid printed circuit board 4 against the existing stress after the package bonding and connection. Moreover, the critical selections for the studs 2 and solder balls 5 in their dimensions, sizes and appearances are also required before the package bonding and connection. Furthermore, an overall CMP (Chemical Mechanical Polishing) to the surfaces of the hard package substrate 3 and the rigid printed circuit board 4 are demanded to perform in order to raise the yield of the package bonding and connection.

Accordingly, there is a need to develop a package structure and a package method of generating extremely low stress to the package substrate and the printed circuit board during the package processes to raise the package yield, and preventing the missing joint or cold welding occurrences.

### SUMMARY OF THE INVENTION

An objective of the present invention is to provide a package structure and a package method, particularly generating extremely low stress to the packaging substrate and the printed circuit board during the packaging processes of the bump, solder miniaturization and the high density package for raising the packaging yield. The circumstances of missing joint and cold welding can be prevented to solve issue that the deformations of the packaging substrate and the printed circuit board due to the stresses occurred thereto caused by the packaging bonding of the bumps, solders and the issue that the connection fractures of the bumps, solders. The effects to the product manufacture yield and the usage lifetime can be avoided and the package bonding failures caused by missing joint and cold welding can be prevented.

The package structure of the present invention comprises an IC bare die, having a plurality of bare die pads formed on a surface of the IC bare die; a flexible packaging substrate, having a plurality of first pads formed on a first surface of the flexible packaging substrate and a plurality of second pads formed on a second surface of the flexible packaging substrate; and a plurality of bumps, previously formed on the first surface of the flexible packaging substrate, and the bumps have different heights and correspond to the first pads respectively, and the bumps connected on the first surface of the flexible packaging substrate are respectively bonded with the bare die pads to package the IC bare die.

The package structure of the present invention further comprises a printed circuit board, having a plurality of contact pads, and the second pads formed on the second surface of the flexible packaging substrate are respectively bonded with the contact pads by solders. Meanwhile, the first surface of the flexible packaging substrate is uneven in the package structure of the present invention.

The package method of the present invention comprises steps of:
providing an IC bare die, having a plurality of bare die pads formed on a surface of the IC bare die;
providing a flexible packaging substrate, having a plurality of first pads formed on an first surface of the flexible packaging substrate and a plurality of second pads formed on a second surface of the flexible packaging substrate;
forming a plurality of bumps on the first surface of the flexible packaging substrate, and the bumps have different heights; and
turning the surface of the IC bare die having the bare die pads toward the first surface of the flexible packaging substrate and implementing pressing or heating to bond the bare die pads respectively with the bumps. Meanwhile, the first surface of the flexible packaging substrate is uneven in the package structure of the present invention.

The package method of the present invention further comprises a step of separating the flexible packaging substrate from a carrier before the step of providing the flexible packaging substrate.

After the step of forming the solders, the package method of the present invention further comprises a step of providing a printed circuit board, having a plurality of contact pads, and turning the contact pads toward the second surface of the flexible packaging substrate, and implementing pressing or heating to connect the flexible packaging substrate with the printed circuit board after the solders contact the contact pads.

### BRIEF DESCRIPTION OF THE DRAWINGS

FIG. 1 depicts a sectional diagram of a package structure according to prior art.

FIG. 2 depicts a sectional diagram of a package structure proceeding package bonding between a hard package substrate and a rigid printed circuit board according to prior art.

FIG. 3 depicts a diagram of a package structure according to the present invention.

FIG. 4 depicts a flowchart of the package method according to the present invention.

### DETAILED DESCRIPTION OF THE INVENTION

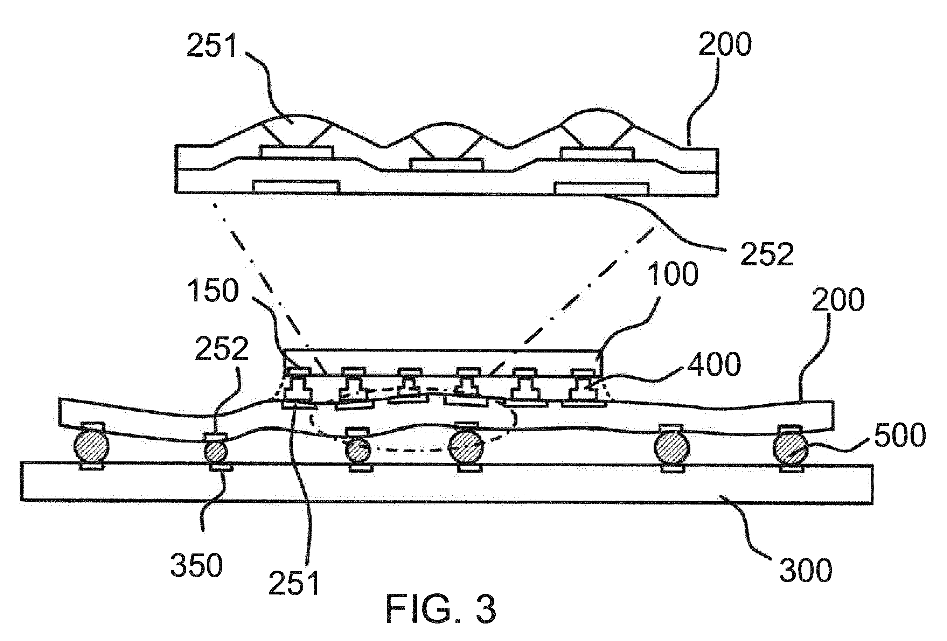

Please refer to FIG. 3, which depicts a diagram of a package structure according to the present invention. The package structure of the present invention comprises an IC bare die 100, a flexible packaging substrate 200, a printed circuit board 300, a plurality of bumps 400, and a plurality of solders 500. As shown in FIG. 3, the IC bare die 100 has a plurality of bare die pads 150 formed on a surface of the IC bare die 100. The flexible packaging substrate 200 has a plurality of first pads 251 formed on a first surface of the flexible packaging substrate 200 and a plurality of second pads 252 formed on a second surface of the flexible packaging substrate 200. The flexible packaging substrate 200 is similar as the rigid multi-layer packaging substrate 3 shown in FIG. 1 and comprises multiple metal layers and multiple dielectric layers. However, the flexible packaging substrate 200 is a multi-layer flexible substrate, and can be deformed in the shape to match the variable bump height to make a good joint. As the flexible packaging substrate 200 is very soft, there is almost no stress in its deformation. Therefore, the flexible packaging substrate 200 possesses "neutral equilibrium" in any shapes. Although, the flexible packaging substrate 200 seems to be outwardly similar and looks like the rigid multi-layer package substrate 3, as regarding the first pads 251 on the first surface of the flexible packaging substrate 200, at least one of the first pads 251 formed on the first surface is not coplanar with the other first pads 251. In other word, the surface of the flexible packaging substrate 200 can possibly be uneven. The bumps 400 are previously formed on the first surface of the flexible packaging substrate 200, i.e. on the respectively corresponding first pads 251 and connected with the first pads 251. Moreover, widths of the bumps 400 which are close to the first pads 251 are larger than widths of the bumps 400 which are close to the corresponding bare die pads 150.

The manufacture of the flexible packaging substrate 200 can be illustrated below: a plurality of metal layers and a plurality of dielectric layers can be alternately formed on a carrier (not shown). The carrier can be a glass, a wafer or a metal carrier for illustrations. The aforesaid metal layers can be formed by a Metal Lift Off process. The dielectric layers can be formed with polyimide as material and by Spin Coating method. The thickness of "one single layer" in the flexible multi-layer substrate employed by the present invention can be smaller than 20µm, and even smaller than 10µm. Meanwhile, the stresses among respective layers are highly consistent because all the dielectric layers are formed by the same material. Therefore, the warpage phenomena of the flexible packaging substrate 200 will not occur after being separated from the carrier. Meanwhile, the flexible packaging substrate 200 possesses the qualities of great flexibility, bendability, ductility and etc. As implementing process of pressing or heating, or a process of pressing and heating simultaneously to the flexible packaging substrate 200, only deformation in local area occurs without affecting the physical characteristics and circuitry characteristics itself due to the "neutral equilibrium" possessed by the flexible packaging substrate 200. The flexible packaging substrate 200 can be a multi-layer flexible substrate, and can be deformed in the shape to match the variable bump height to realize a good joint. As the flexible packaging substrate 200, which is very soft and the flexibility can function during the packaging process, there is almost no stress in the deformation of the flexible packaging substrate 200. Moreover, the flexible packaging substrate 200 according to the present invention meets the requirement of the MIT flex test standards of bending curvature radius test R<10mm, and even the standards of bending curvature radius test R<1mm.

Meanwhile, the procedure of connecting the bumps 400 and the first pads 251 can be executed before or after the separation of the flexible packaging substrate 200 from the carrier. In the scenario that the connection procedure is after the separation, a special designed clamp system to clamp the flexible packaging substrate 200 and a support member located under the flexible packaging substrate 200 can be employed for executing the procedure of connecting the bumps 400 and the first pads 251. Alternatively, the flexible packaging substrate 200 can be attached on a vacuum suction carrier for the executing the procedure. However, there is no specific related limitation to the present invention. As aforementioned, the flexible packaging substrate 200 possesses the qualities of great flexibility, bendability, ductility and etc. Accordingly, in the packaging process or after the packaging process, the flexible packaging substrate 200 of the present invention can possess the "neutral equilibrium" which is the most significant features of the present invention as implementing process of pressing or heating, or a process of simultaneously pressing and heating.

Consequently, after pressing or heating is implemented to the IC bare die 100 and the flexible packaging substrate 200 to package the IC bare die 100 with the flexible packaging substrate 200, the aforesaid package bonding merely generates extremely low stress to the IC bare die 100, the flexible packaging substrate 200 and the bumps 400 due to the "neutral equilibrium" adaptability of the flexible packaging substrate 200. Particularly as regarding the thickness (the distance between two metal layers or the thickness of one dielectric layer) of the present possibly manufactured package substrate can be smaller than 50µm, and even smaller than 30µm. Either during the packaging process or after the packaging process, the fracture of the bump package bonding due to the stress or leads to the failure of electronics devices in prior arts will never occur. Meanwhile, the phenomena of the uneven surfaces because both the IC bare die 100 and the printed circuit board 300 in FIG. 2 are hard and rigid subjects, and the flexible packaging substrate 200 and the printed circuit board 300 in FIG. 3 have uneven thicknesses, inevitably. Or, the flexible packaging substrate 200 and the printed circuit board 300 are uneven themselves, or the arrangement of the metal layers and the dielectric layers is impossible averaged because of the circuitry design. Consequently the surfaces of the flexible packaging substrate 200 and the printed circuit board 300 are not even eventually. Moreover, no matter how meticulously the bumps 400 or the solders 500 are manufactured, certain differences of dimensions, sizes and appearances of many bumps 400 or many solders 500 must exist. By the foregoing reasons, such packaging and bonding failures of the electronic devices caused by missing joint or cold welding as described in prior arts can never happen.

The manufacture process of the bumps can be general tin solder bumps, gold bumps or gold stud bumps for illustrations. However, regardless of what manufacture process the bumps are made by, the heights of the bumps must exist certain deviations. Even in the assumed best manufacture condition, there will be 0.5µm∼3µm deviations. As aforementioned in the high density package process, the heights of the bumps can be merely 20µm, or even less and the 0.5µm-3µm deviations will possibly cause the situations of missing joint or cold welding. Similarly, even in the assumed best manufacture condition of substrate, the 1µm∼5µm existed deviation is commonly observed as regarding of the coplanarity of the substrate pads. The aforesaid unevenness of the substrate or the non-coplanarity of the substrate pads can lead to the situations of missing joint or cold welding. However, the "neutral equilibrium" adaptability of the flexible packaging substrate of the present invention can solve the problems of missing joint or cold welding due to the package height deviations.

Furthermore, the printed circuit board 300 of the present invention has a plurality of contact pads 350. The second pads 252 are formed on the second surface of the flexible packaging substrate 200. The second pads 252 are respectively bonded with the contact pads 350 by solders 500. As aforementioned, the flexible packaging substrate 200 of the present invention possesses the qualities of no warpages and flexibility, bendability, ductility and etc. In the packaging process or after the packaging process, the flexible packaging substrate 200 of the present invention can possess the "neutral equilibrium" adaptability which is the most significant features of the present invention as implementing process of pressing or heating, or a process of simultaneously pressing and heating.

Therefore, pressing or heating is implemented to the IC bare die 100, the flexible packaging substrate 200, and the printed circuit board 300 to connect the flexible packaging substrate 200 to the printed circuit board 300 with the solders 500, merely extremely low stress is generated to the IC bare die 100, the flexible packaging substrate 200, the printed circuit board 300, the bumps 400 and the solders 500. Particularly as regarding the layer thickness (the distance between two metal layers or the thickness of one dielectric layer) of this packaging substrate can be smaller than 50µm, and even smaller than 30µm. Either during the packaging process or after the packaging process, the fracture of the bump or solder package bonding due to the stress or leads to the failure of electronics devices in prior arts will never occur.

Accordingly, in the package technology field which the miniaturization of the bumps and solders continues and the package density is constantly promoted, with the "neutral equilibrium" adaptability of the flexible packaging substrate provided with the present invention, merely extremely low stress is generated to the flexible packaging substrate 200 and the printed circuit board 300. The present invention can solve the issues that the stress generated to the packaging substrate and the printed circuit board by the package bonding of the bumps and solders; the product manufacture yield and the usage lifetime affected by the bump and solder connection fractures due to the deformations of the packaging substrate and the printed circuit board.

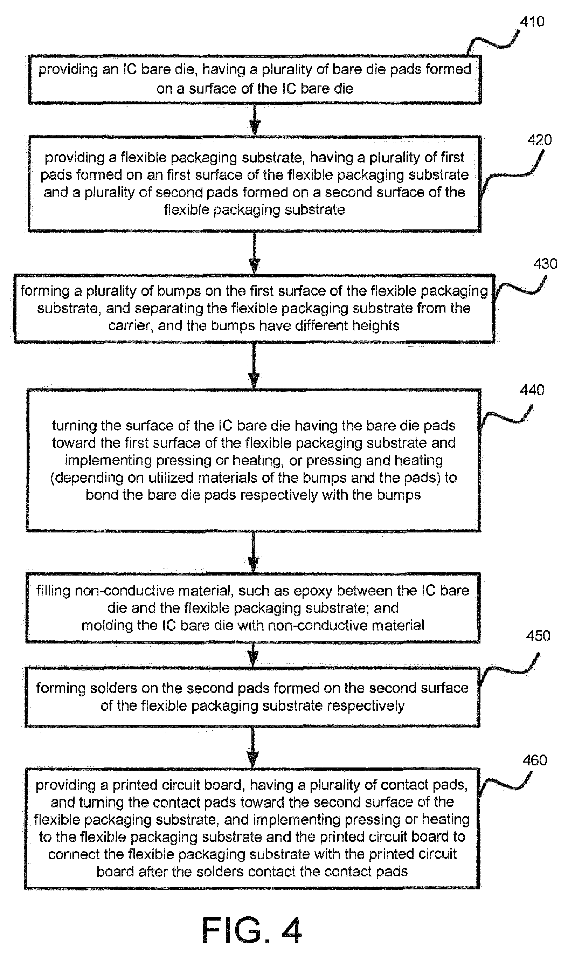

Meanwhile, the present invention provides a package method. Please refer to FIG. 3 and FIG. 4. FIG. 4 depicts a flowchart of the package method according to the present invention. The package method comprises steps of:

Step 410: providing an IC bare die 100, having a plurality of bare die pads 150 formed on a surface of the IC bare die 100;

Step 420: providing a flexible packaging substrate 200, having a plurality of first pads 251 formed on an first surface of the flexible packaging substrate 200 and a plurality of second pads 252 formed on a second surface of the flexible packaging substrate 200. As aforementioned, the flexible packaging substrate 200 can be previously formed on a carrier. Alternatively, the flexible packaging substrate 200 can be separated from the carrier and then attached on a vacuum suction carrier;

Step 430: forming a plurality of bumps 400 on the first surface of the flexible packaging substrate 200, and separating the flexible packaging substrate 200 from the carrier (or the vacuum suction carrier), and the bumps have different heights; and

Step 440: turning the surface of the IC bare die 100 having the bare die pads 150 toward the first surface of the flexible packaging substrate 200 and implementing pressing or heating, or pressing and heating (depending on utilized materials of the bumps and the pads) to the IC bare die 100 and the flexible packaging substrate 200 to bond the bare die pads 150 respectively with the bumps 400. This package step merely generates extremely low stress to the IC bare die 100 and the flexible packaging substrate 200 because the flexible packaging substrate 200 possesses adaptabilities of no warpages and missing joint, flexibility, bendability, ductility and etc. No missing joint and cold welding occur to results in the package bonding failures of electronic devices;

After Step 440, the present invention can further comprise a step of filling non-conductive material, such as epoxy between the IC bare die 100 and the flexible packaging substrate 200, i.e. an underfill step. Then, after the underfill step, the present invention can further comprise a step of molding the IC bare die 100 with non-conductive material, such as epoxy.

Step 450: forming solders 500 on the second pads formed on the second surface of the flexible packaging substrate 200 respectively;

Step 460: providing a printed circuit board 300, having a plurality of contact pads 350, and turning the contact pads 350 toward the second surface of the flexible packaging substrate 200, and implementing pressing or heating to the flexible packaging substrate 200 and the printed circuit board 300 to connect the flexible packaging substrate 200 with the printed circuit board 300 after the solders contact the contact pads after the step of forming the solders. Because the flexible packaging substrate 200 possesses adaptabilities of no warpages and flexibility, bendability, ductility and etc, the package bonding of this step merely generates extremely low stress to the IC bare die 100, the flexible packaging substrate 200 and the printed circuit board 300. No missing joint and cold welding occur to results in the package bonding failures of electronic devices.

In conclusion, the "neutral equilibrium" adaptability of the package structure and package method according to the present invention is particularly applicable in the package structures of the bump, solder miniaturization and the high density package. According to the present invention, merely extremely low stress is generated to the packaging substrate and the printed circuit board. The effects to the product manufacture yield and the usage lifetime can be avoided by solving issue that the deformations of the packaging substrate and the printed circuit board due to the stresses occurred thereto caused by the packaging bonding of the bumps, solders and the issue that the connection fractures of the bumps, solders. Beside, the circumstances of missing joint and cold welding due to differences of dimensions, sizes and appearances of the bumps or the solders can be prevented.

As is understood by a person skilled in the art, the foregoing preferred embodiments of the present invention are illustrative rather than limiting of the present invention. It is intended that they cover various modifications and similar arrangements be included within the spirit and scope of the appended claims, the scope of which should be accorded the broadest interpretation so as to encompass all such modifications and similar structure.

## Claims

1. A package structure, **characterized in that** the package structure comprises:
an IC bare die (100), having a plurality of bare die pads (150) formed on a surface of the IC bare die (100);
a flexible packaging substrate (200), having a plurality of first pads (251) formed on an first surface of the flexible packaging substrate (200) and a plurality of second pads (252) formed on a second surface of the flexible packaging substrate (200); and
a plurality of bumps (400), formed on the first surface of the flexible packaging substrate (200), and the bumps (400) have different heights and correspond to the first pads (251) respectively, and the bumps (400) connected on the first surface of the flexible packaging substrate (200) are respectively bonded with the bare die pads (150).

2. The package structure according to claim 1, **characterized in that** at least one of the first pads (251) formed on the first surface is not coplanar with the other first pads (251).

3. The package structure according to claim 1, **characterized in that** the package structure further comprises a printed circuit board (300), having a plurality of contact pads (350), and the second pads (252) formed on the second surface of the flexible packaging substrate (200) are respectively bonded with the contact pads (350) by solders (500).

4. The package structure according to claim 1, **characterized in that** widths of the bumps (400) which are close to the first pads (251) are larger than widths of the bumps (400) which are close to the corresponding bare die pads (150).

5. A package method, comprising steps of:
providing an IC bare die (100), having a plurality of bare die pads (150) formed on a surface of the IC bare die (100);
providing a flexible packaging substrate (200), having a plurality of first pads (251) formed on an first surface of the flexible packaging substrate (200) and a plurality of second pads (252) formed on a second surface of the flexible packaging substrate (200);
forming a plurality of bumps (400) on the first surface of the flexible packaging substrate (200), and the bumps (400) have different heights; and
turning the surface of the IC bare die (100) having the bare die pads (150) toward the first surface of the flexible packaging substrate (200) and implementing pressing or heating to bond the bare die pads (150) respectively with the bumps (400).

6. The package method according to claim 5, **characterized in that** at least one of the first pads (251) formed on the first surface is not coplanar with the other first pads (251).

7. The package method according to claim 5, further comprising a step of forming solders (500) on the second pads (252) respectively after the step of implementing pressing or heating.

8. The package method according to claim 5, **characterized in that** the package method further comprises a step of separating the flexible packaging substrate (200) from a carrier before the step of providing the flexible packaging substrate (200).

9. The package method according to claim 7, **characterized in that** the package method further comprises a step of providing a printed circuit board (300), having a plurality of contact pads (350), and implementing pressing or heating to connect the contact pads (350) of the printed circuit board (300) with the solders (500) of the flexible packaging substrate (200) after the step of forming the solders (500).
